# EUROPEAN PATENT APPLICATION

(11) **EP 2 068 352 A1**
(43) Date of publication of application: **10.06.2009**
(21) Application number: 07829202.6
(22) Date of filing: 04.10.2007
(51) Int. Cl.: H01L 21/301, B32B 27/00, C09J 7/02, C09J 201/00

(54) **FILM FOR SEMICONDUCTOR, METHOD FOR PRODUCING FILM FOR SEMICONDUCTOR, AND SEMICONDUCTOR DEVICE**

(30) Priority: 06.10.2006 JP 2006275243; 11.09.2007 JP 2007234869
(71) Applicant: Sumitomo Bakelite Company, Ltd., Tokyo 140-0002 (JP)
(72) Inventor: HIRANO, Takashi, Shinagawa-ku Tokyo 1400002 (JP); SASAKI, Akitsugu, Shinagawa-ku Tokyo 1400002 (JP); ODA, Naoya, Shinagawa-ku Tokyo 1400002 (JP)
(74) Representative: Solf, Alexander
(86) International application number: PCT/JP2007/069464
(87) International publication number: WO 2008/047610

(57) **Abstract**

A film for use in manufacturing semiconductor devices of the present invention includes a bonding layer having a first surface and a second surface, a first adhesive layer bonding to the second surface of the bonding layer and a second adhesive layer bonding to the first adhesive layer at a side opposite to the bonding layer wherein the second adhesive layer has an outer peripheral portion extending beyond an outer peripheral edge of the first adhesive layer. Further, the film is used in dicing a semiconductor wafer in a state that the semiconductor wafer is bonded to the first surface of the bonding layer while a wafer ring is bonded to the outer peripheral portion of the second adhesive layer wherein the bonding force A₁ (cN/25mm) of the first adhesive layer to the bonding layer is smaller than the bonding force A₂ (cN/25mm) of the second adhesive layer to the wafer ring.

## Description

### BACKGROUND OF THE INVENTION

### Field of the invention

The present invention relates to a film for use in manufacturing semiconductor devices, a method for producing the film and a semiconductor device.

### Description of the Prior Art

Responsive to the recent trend of high functionality of electronic devices and expansion of their use to mobile applications, there is an increasing demand for a semiconductor device with high density and high integration. Thus, an increase in the capacity and density of an IC package is currently in progress. In a method of manufacturing the semiconductor device, an adhesive sheet is attached to a semiconductor wafer made of silicon, gallium, arsenic and the like. The periphery of the semiconductor wafer is fixed by a wafer ring. The semiconductor wafer is diced (or segmented) into individual semiconductor elements in a dicing step. Thereafter, the semiconductor elements thus segmented are picked up in an expanding step. Then, the semiconductor elements are transferred to a die bonding step in which they are mounted on a metal lead frame or a substrate (e.g., a tape substrate or an organic hard substrate).

The semiconductor elements picked up are bonded, in the die bonding step, to the lead frame or the substrate with a liquid phase die attach material such as a liquid epoxy adhesive or the like, thus producing a semiconductor device.

The semiconductor wafer is becoming thinner and thinner to meet the need of overlapping the semiconductor elements in multiple stages. In case of using resin paste, one of the conventional die bonding materials, as an adhesive, it is difficult to apply the adhesive in a proper amount. Therefore, there is a case that the resin paste is squeezed out from between the semiconductor elements, or the semiconductor elements are warped after the resin paste has been cured. This may sometimes reduce the reliability at the time when the semiconductor elements are assembled into a package. Moreover, the step of applying the resin paste is onerous and cumbersome to carry out. Therefore, a demand has existed for the improvement of the resin paste application step with a view to simplify the process.

As a solution to the problem noted above, use of a film-like adhesive as the die attach material in place of the liquid die attach material has been proposed, and the film-like adhesive is already used by some manufacturers (see, e.g., JP2002-353252A and JP2002-294177A). In an effort to shorten the process, some manufacturers make use of an adhesive bonding film formed by combining an adhesive sheet and a film-like die attach material together.

### SUMMARY OF THE INVENTION

It is an object of the present invention to provide a film for use in manufacturing semiconductor devices capable of satisfying the function required in the portion of an adhesive bonding film to be bonded to a semiconductor wafer and the function required in the portion of the adhesive bonding film to be bonded to a wafer ring, both of the functions differing from each other in the adhesive bonding film formed by combining an adhesive sheet and a film-like die attach material together, a method for producing the film, and a semiconductor device manufactured by use of the film.

The above object can be accomplished by subject matters (1) to (8) of the present invention summarized below.
(1) A film for use in manufacturing semiconductor devices, the film having a first portion and a second portion different from the first portion, the film being adapted to be used in dicing a semiconductor wafer in a state that the semiconductor wafer is bonded to the first portion of the film while a wafer ring is bonded to the second portion of the film, the film comprising:
   a bonding layer having a first surface which forms the first portion of the film and a second surface opposite to the first surface;
   a first adhesive layer bonding to the second surface of the bonding layer; and
   a second adhesive layer bonding to the first adhesive layer at a side opposite to the bonding layer, the second adhesive layer having an outer peripheral portion extending beyond an outer peripheral edge of the first adhesive layer wherein the outer peripheral portion acts as the second portion of the film,
   wherein the bonding force A₁ (cN/25mm) of the first adhesive layer to the bonding layer is smaller than the bonding force A₂ (cN/25mm) of the second adhesive layer to the wafer ring.
(2) The film for use in manufacturing semiconductor devices according to item (1), wherein the ratio (A₂/A₁) of the bonding force A₁ to the bonding force A₂ is in the range of 1.2 to 100.
(3) The film for use in manufacturing semiconductor devices according to item (1), wherein the bonding force A₁ is in the range of 10 to 80 cN/25mm.
(4) The film for use in manufacturing semiconductor devices according to item (1), wherein the bonding force A₂ is in the range of 100 to 1,000 cN/25mm.
(5) The film for use in manufacturing semiconductor devices according to item (1), wherein the bonding force A₃ (cN/25mm) of the bonding layer to the semiconductor wafer is greater than the bonding force A₁.
(6) The film for use in manufacturing semiconductor devices according to item (1), wherein the bonding layer has a release film.
(7) A method for producing the film according to item (1), comprising:
   preparing a first base film and a second base film;
   obtaining a first laminated body by forming the bonding layer on the first base film and then the first adhesive layer on the bonding layer at a side opposite to the first base film;
   removing outer peripheral portions of the bonding layer and the first adhesive layer while leaving the first base film intact, the outer peripheral portions lying outside effective regions of the bonding layer and the first adhesive layer;
   obtaining a second laminated body by forming the second adhesive layer on the second base film; and
   laminating the second laminated body on the first adhesive layer so that the second adhesive layer and the first adhesive layer can adjoin to each other.
(8) A semiconductor device manufactured by use of the film according to item (1).

### BRIEF DESCRIPTION OF THE DRAWINGS

Fig. 1 is a sectional view showing one example of a film for use in manufacturing semiconductor devices.
Fig. 2 is a sectional view showing another example of the film for use in manufacturing semiconductor devices.
Figs. 3A through 3D are sectional views illustrating a process for producing a film for use in manufacturing semiconductor devices.
Figs. 4A and 4B are sectional views illustrating the process for producing a film for use in manufacturing semiconductor devices.
Figs. 5A through 5D are sectional views illustrating another process for producing a film for use in manufacturing semiconductor devices.
Figs. 6A through 6D are pattern diagrams illustrating a process for manufacturing a semiconductor device.

### DETAILED DESCRIPTION OF THE PREFERRED EMBODIMENTS

Hereinafter, a film for use in manufacturing semiconductor devices and a semiconductor device in accordance with the present invention will be described in detail.

The film for use in manufacturing semiconductor devices of the present invention includes a bonding layer having a first surface and a second surface opposite to the first surface, a first adhesive layer bonding to the second surface of the bonding layer and a second adhesive layer bonding to the first adhesive layer at a side opposite to the bonding layer wherein the second adhesive layer has an outer peripheral portion extending beyond an outer peripheral edge of the first adhesive layer. The film is used in dicing a semiconductor wafer in a state that the semiconductor wafer is bonded to the first surface of the bonding layer while a wafer ring is bonded to the outer peripheral portion of the second adhesive layer, wherein the bonding force A₁ (cN/25mm) of the first adhesive layer to the bonding layer is smaller than the bonding force A₂ (cN/25mm) of the second adhesive layer to the wafer ring.

The semiconductor device of the present invention is manufactured by use of the film as mentioned above.

First, description will be made on the film for use in manufacturing semiconductor devices.

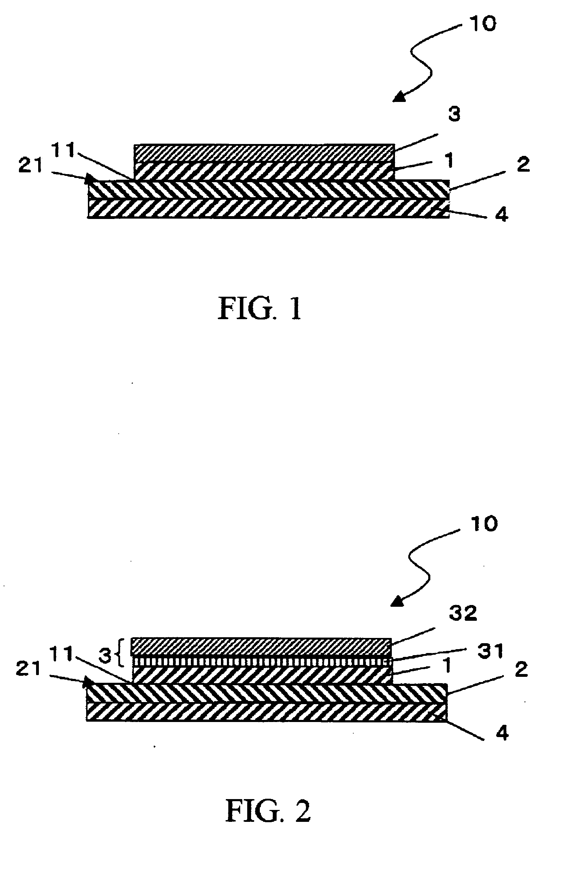

The film for use in manufacturing semiconductor devices 10 includes a first adhesive layer 1, a second adhesive layer 2 and a bonding layer 3. As shown in Fig. 1, the bonding layer 3, the first adhesive layer 1 and the second adhesive layer 2 are bonded together in the named order. The second adhesive layer 2 has an outer peripheral portion 21 extending beyond the outer peripheral edge 11 of the first adhesive layer 1. A second base film (a support film) 4 is arranged below the second adhesive layer 2 (on the lower side of the second adhesive layer 2 in Fig. 1).

Hereinafter, description will be made on the respective components of the film 10.

As the first adhesive layer 1, it is possible to use various adhesives conventionally used in such an application. Specifically, the first adhesive layer 1 is composed of a first resin composition including an acryl-based adhesive, a rubber-based adhesive or the like.

Examples of the acryl-based adhesive include a resin composed of (metha) acrylic acid and its ester, and a copolymer of (metha) acrylic acid or its ester and an unsaturated monomer polymerizable therewith (e.g., vinyl acetate, styrene or acrylonitrile). Two or more of these materials may be used in combination. Among them, it is preferable to use a copolymer of one or more members selected from the group consisting of (metha) acrylic acid methyl, (metha) acrylic acid ethyl hexyl and (metha) acrylic acid butyl and one or more members selected from the group consisting of (metha) acrylic acid hydroxy ethyl and vinyl acetate. This makes it easy to control the adhesion and adhesiveness of the first adhesive layer 1 relative to an adherend.

In order to control the adhesiveness (bondability), urethane acrylate, an acrylate monomer, or a monomer and an oligomer of an isocyanate compound such as a poly-valent isocyanate compound (e.g., 2,4-tolylenediisocyanate or 2,6-tolylenediisocyanate) may be added to the first resin composition. For the purpose of increasing the bonding strength and the shear strength, it may be possible to add a tackifier material such as a rosin resin, a terpene resin, a coumarone resin, a phenol resin, a styrene resin, an aliphatic petroleum resin, an aromatic petroleum resin, an aliphatic aromatic petroleum resin, or the like.

The bonding force A₁ of the first adhesive layer 1 to the bonding layer 3 is smaller than the banding force A₂ of the second adhesive layer 2 to the wafer ring. Specifically, the bonding force A₁ can be adjusted by changing the kinds of the acryl-based resins or the like, the kinds of the monomers or the like, the content thereof, and so forth.

Taking an example, 1 to 50 parts by weight of an acrylate monomer and 0.1 to 10 parts by weight of an isocyanate compound are blended with 100 parts by weight of the acryl-based resin.

In this regard, the bonding force A₁ (or the bonding force A₂) refers to an adhesive force measured by, e.g., cutting one adhesive film composed of constituent material of an adhesive layer (the first adhesive layer 1 or the second adhesive layer 2) into a 25 mm-wide strip, adhesively attaching the strip to another adhesive film composed of the same constituent material of the one adhesive film at 23°C (the room temperature) and peeling the one adhesive film cut into 25 mm-wide stripe from the another adhesive film at 23°C (the room temperature) with a peeling angle of 180 degrees (at which time the pulling speed of the adhesive film is 300mm/min).

Although the bonding force A₁ can be adjusted by the kinds of the acryl-based resin, it may also be possible to reduce the bonding force A₁ by blending a radiation-polymerizable polymerization initiator and then irradiating ultraviolet rays or other rays, or by polymerizing a monomer (e.g., an acrylate monomer or an isocyanate monomer).

The bonding force A₁ may be, but is not particularly limited to, preferably in the range of 10 to 80 cN/25mm and more preferably in the range of 30 to 60 cN/25mm. If the bonding force A₁ falls within this range, the dicing property and the pickup property are improved among others.

The thickness of the first adhesive layer 1 may be, but is not particularly limited to, preferably in the range of 1 to 100 µm and more preferably in the range of 3 to 20 µm. If the thickness is smaller than the lower limit value noted above, it is sometimes difficult to secure a great enough adhesive force. Even if the thickness is set to exceed the upper limit value noted above, there is no influence on the properties of the first adhesive layer 1, with no advantage obtained. If the thickness falls within the above range, the dicing property and the pickup property are improved among others.

The second adhesive layer 2 exhibits greater adhesiveness than the first adhesive layer 1 mentioned above. Namely, the bonding force A₁ (cN/25mm) of the first adhesive layer 1 to the bonding layer 3 is smaller than the bonding force A₂ (cN/25mm) of the second adhesive layer 2 to the wafer ring. This ensures that the workability in dicing the semiconductor wafer and the ease of pickup of the diced and segmented semiconductor wafers (semiconductor elements) are compatible. In particular, the ease of pickup is secured in case of thin semiconductor elements having a thickness of 200 µm or less.

As the second adhesive layer 2, it is possible to use the same material as that used in forming the first adhesive layer 1. Specifically, the second adhesive layer 2 is composed of a second resin composition including an acryl-based adhesive, a rubber-based adhesive or the like.

Examples of the acryl-based adhesive include a resin composed of (metha) acrylic acid and ester thereof, and a copolymer of (metha) acrylic acid or its ester and an unsaturated monomer polymerizable therewith (e.g., vinyl acetate, styrene or acrylonitrile). Two or more of these materials may be used in combination. Among them, it is preferable to use a copolymer of one or more members selected from the group consisting of (metha) acrylic acid methyl, (metha) acrylic acid ethyl hexyl and (metha) acrylic acid butyl and one or more members selected from the group consisting of (metha) acrylic acid hydroxy ethyl and vinyl acetate. This makes it easy to control the adhesion and adhesiveness of the second adhesive layer 2 relative to an adherend.

In order to control the adhesiveness (bondability), urethane acrylate, an acrylate monomer, or a monomer and an oligomer of an isocyanate compound such as a poly-valent isocyanate compound (e.g., 2,4-tolylenediisocyanate or 2,6-tolylenediisocyanate) may be added to the second resin composition. For the purpose of increasing the bonding strength and the shear strength, it may be possible to add a tackifier material such as a rosin resin, a terpene resin, a coumarone resin, a phenol resin, a styrene resin, an aliphatic petroleum resin, an aromatic petroleum resin, an aliphatic aromatic petroleum resin, or the like.

When dicing a semiconductor wafer, the film 10 is used in such a manner that a wafer ring is bonded to the outer peripheral portion 21 of the second adhesive layer 2 which is not covered by the first adhesive layer 1. The bonding force A₂ (cN/25mm) of the second adhesive layer 2 to the wafer ring may be, but is not particularly limited to, preferably in the range of 100 to 1,000 cN/25mm and more preferably in the range of 400 to 800 cN/25mm. If the bonding force A₂ falls within this range, it is possible to reduce the possibility that the semiconductor elements are detached from the film 10 during an expanding step, thereby providing a great enough bonding force between the second adhesive layer 2 and the wafer ring.

The bonding force A₂ can be adjusted by changing the kinds of the acryl-based resins or the like, the kinds of the monomers or the like, the content thereof, and so forth. Taking an example, 1 to 50 parts by weight of urethane acrylate and 0.5 to 10 parts by weight of an isocyanate compound are blended with 100 parts by weight of the acryl-based resin.

The ratio (A₂/A₁) of the bonding force A₁ to the bonding force A₂ may be, but is not particularly limited to, preferably in the range of 1.2 to 100 and more preferably in the range of 5 to 30. If the ratio falls within this range, the dicing property and the pickup property are improved among others.

The thickness of the second adhesive layer 2 may be, but is not particularly limited to, preferably in the range of 1 to 100 µm and more preferably in the range of 3 to 20 µm. If the thickness is smaller than the lower limit value noted above, it is sometimes difficult to secure a great enough adhesive force. Even if the thickness is set to exceed the upper limit value noted above, no advantageous effect is attained.

The bonding layer 3 is composed of a third resin composition including, e.g., a thermosetting resin and a curing agent. This assists in increasing the bondability and post-curing heat resistance.

Examples of the thermosetting resin includes: novolac type phenol resins such as a phenol novolac resin, a cresol novolac resin, a bisphenol A novolac resin and the like; phenol resins such as a resol phenol resin and the like; bisphenol type epoxy resins such as a bisphenol A epoxy resin, a bisphenol F epoxy resin and the like; novolac type epoxy resins such as a novolac epoxy resin, a cresol novolac epoxy resin and the like; epoxy resins such as a biphenyl type epoxy resin, a stilbene type epoxy resin, a triphenol methane type epoxy resin, an alkyl-modified triphenol methane type epoxy resin, a triazine nucleus-containing epoxy resin, dicyclopentadiene-modified phenol type epoxy resin and the like; resins with a triazine ring such as an urea resin, a melamine resin and the like; an unsaturated polyester resin; a bismaleimide resin; a polyurethane resin; a diallyl phthalate resin; a silicon resin; a resin with a benzooxazine ring; and a cyanate ester resin. One or more of these resins may be used independently or in combination. Among them, it is preferred to use the epoxy resins. This makes it possible to increase the heat resistance and the adhesion of the bonding layer 3.

The content of the thermosetting resin may be, but is not limited to, preferably in the range of 30 to 60 wt% and more preferably in the range of 40 to 50 wt% based on the total weight of the third resin composition. If the content is smaller than the lower limit value noted above, it is sometimes the case that the effect of increasing the post-curing elastic modulus of the bonding layer 3 is reduced. If the content is greater than the upper limit value noted above, it is sometimes the case that the effect of increasing the film forming ability is reduced. By setting the content of the thermosetting resin within the above-noted range, it is possible to improve the initial embeddedness of the semiconductor elements to a substrate (the initial embeddedness of the semiconductor elements against the unevenness of a substrate).

It is preferred that the third resin composition further contains a curing agent (particularly, a phenol-based curing agent in case of using an epoxy resin as the thermosetting resin).

Examples of the curing agent include: amine-based curing agents including aliphatic polyamines such as diethylene triamine (DETA), triethylene tetramine (TETA), m-xylylene diamine (MXDA) and the like, aromatic polyamines such as diamino diphenyl methane (DDM), m-phenylene diamine (MPDA), diamino diphenyl sulfone (DDS) and the like, and polyamine compounds such as dicyane diamine (DICY), organic acid dihydrazide and like; acid anhydride-based curing agents including alicyclic acid anhydride (liquid acid anhydride) such as hexahydrophthalic anhydride (HHPA), methyltetrahydrophthalic anhydride (MTHPA) and the like, and aromatic acid anhydride such as trimellitic anhydride (TMA), pyromellitic anhydride (PMDA), benzophenone tetracarboxylic anhydride (BTDA) and the like; and phenol-based curing agents including a phenol resin. Among them, it is preferred to use phenol-based curing agents. Examples of the phenol-based curing agents include compounds: various kinds of isomers of bisphenols such as bis(4-hydroxy-3,5-dimethyl phenyl)methane (commonly called tetramethyl bisphenol F), 4,4'-sulfonyl diphenol, 4,4'-isoproyridene diphenol (commonly called bisphenol A), bis(4-hydroxy phenyl)methane, bis(2-hydroxy phenyl)methane, (2-hydroxy phenyl)(4-hydroxy phenyl)methane, a mixture of bis (4-hydroxy phenyl)methane, bis(2-hydroxy phenyl)methane and (2-hydroxy phenyl) (4-hydroxy phenyl)methane (e.g., bisphenol F-D, a product of Honshu Chemical Industry Co., Ltd.) and the like, dihydroxy benzenes such as 1,2-benzene diol, 1,3-benzene diol, 1,4-benzene diol and the like, trihydroxy benzenes such as 1,2,4-benzene triol and the like, and dihydroxy naphthalenes such as 1,6-dihydroxy naphthalenes and the like; and various kinds of isomers of biphenols such as 2,2'-biphenol, 4,4'-biphenol and the like.

The content of the curing agent (particularly, the phenol-based curing agent) may be, but is not limited to, preferably in the range of 15 to 40 wt% and more preferably in the range of 20 to 30 wt% of the total weight of the third resin composition. If the content is smaller than the lower limit value noted above, the effect of increasing the heat resistance is sometimes reduced. If the content is greater than the upper limit value noted above, it is sometimes the case that the preservative quality is reduced.

In case where the epoxy resin is used as the thermosetting resin, the content of the curing agent can be determined by calculating the equivalent ratio of an epoxy equivalent and a curing agent equivalent. The ratio of the epoxy equivalent of the epoxy resin and the functional group equivalent of the curing agent (e.g., the hydroxyl group equivalent in case of the phenol resin) may be preferably in the range of 0.5 to 1.5 and more preferably in the range of 0.7 to 1.3. If the equivalent ratio is smaller than the lower limit value noted above, it is sometimes the case that the preservative quality is reduced. If the equivalent ratio is greater than the upper limit value noted above, the effect of increasing the heat resistance is sometimes reduced.

Although not particularly limited, it is preferred that the third resin composition further contains a curing catalyst. This makes it possible to increase the curability of the bonding layer 3.

Examples of the curing catalyst include: amine-based catalysts such as imidazoles, 1,8-diazabicyclo(5,4,0)undecene and the like; and phosphorous catalysts such as triphenyl phosphine and the like. Among them, it is preferred to use the imidazoles. This ensures that the high speed curability and the preservative quality are compatible.

Examples of the imidazoles include 1-benzil-2-methyl imidazole, 1-benzil-2-phenyl imidazole, 1-cyanoethyl-2-ethyl-4-methyl imidazole, 2-phenyl-4-methyl imidazole, 1-cyanoethyl-2-phenyl imidazolium trimeritate, 2,4-diamino-6-[2'-methyl imidazolyl-(1')]-ethyl-s-triazine, 2,4-diamino-6-[2'-ethyl-4'-methyl imidazolyl-(1')]-ethyl-s-triazine, 2,4-diamino-6-[2'-methyl imidazolyl-(1')]-ethyl-s-triazine isocyanuric acid adduct, 2-phenyl imidazole isocyanuric acid adduct, 2-phenyl-4,5-dihydroxy methyl imidazole, 2-phenyl-4-methyl-5-hydroxy methyl imidazole, 2,4-diamino-6-vinyl-s-triazine, 2,4-diamino-6-vinyl-s-triazine isocyanuric acid adduct, 2,4-diamino-6-methacryloyloxy ethyl-s-triazine, and 2,4-diamino-6-methacryloyloxy ethyl-s-triazine isocyanuric acid adduct. Among them, it is preferred to use 2-phenyl-4,5-dihydroxy methyl imidazole or 2-phenyl-4-methyl-5-hydroxy methyl imidazole. This makes it possible to improve the preservative quality among others.

The content of the curing catalyst may be, but is not limited to, preferably in the range of 0.01 to 30 parts by weight and more preferably in the range of 0.5 to 10 parts by weight, based on 100 parts by weight of the thermosetting resin. If the content is smaller than the lower limit value noted above, it is sometimes the case that the curability becomes insufficient. If the content is greater than the upper limit value noted above, the preservative quality is sometimes reduced.

The average particle size of the curing catalyst may be, but is not limited to, preferably 10 µm or less and more preferably in the range of 1 to 5 µm. If the average particle size falls within this range, the curing catalyst shows superior reactivity among others.

Although not particularly limited, it is preferred that the third resin composition further contains a thermoplastic resin. This makes it possible to improve the film forming ability of the bonding layer 3.

Examples of the thermoplastic resin include: polyimide-based resins such as a polyimide resin, a polyether imide resin and the like; polyamide-based resins such as a polyamide resin, a polyamide imide resin and the like; acryl-based resins; and phenoxy resins. Among them, it is preferred to use the acryl-based resins. Since the acryl-based resins show a low glass transition temperature, use of the same makes it possible to improve the initial adhesion of the bonding layer 3.

The acryl-based resins refer to acrylic acids and their derivatives. Examples of the acryl-based resins include: acrylic acid ester such as acrylic acid, methacrylic acid, acrylic acid methyl, acrylic acid ethyl and the like; methacrylic acid ester such as methacrylic acid methyl, methacrylic acid ethyl and the like; polymers such as acrylonitrile, acryl amide and the like; and copolymers of these polymers and other monomers.

Among the acryl-based resins, it is preferred to use acryl-based resins (particularly, acrylic acid ester copolymers) including compounds (copolymerizing monomer components) with an epoxy group, a hydroxyl group, a carboxyl group, a nitrile group or the like. This makes it possible to improve the adhesion of the bonding layer 3 to an adherend such as a semiconductor element or the like. Examples of the compounds having the functional groups mentioned above include glycidyl methacrylate having a glycidyl ether group, hydroxy methacrylate having a hydroxyl group, carboxyl methacrylate having a carboxyl group, and acrylonitrile having a nitrile group.

The content of the compounds having the functional groups mentioned above may be, but is not limited to, preferably in the range of 0.5 to 40 wt% and more preferably in the range of 5 to 30 wt% of the total weight of the acryl-based resins. If the content is smaller than the lower limit value noted above, the effect of improving the adhesion is sometimes reduced. If the content is greater than the upper limit value noted above, it is sometimes the case that the adhesive force becomes too great, which leads to reduction in the effect of improving the workability.

The glass transition temperature of the thermoplastic resin may be, but is not limited to, preferably in the range of -25 to 120°C, more preferably -20 to 60°C and most preferably in the range of -10 to 50°C. If the glass transition temperature is lower than the lower limit value noted above, it is sometimes the case that the adhesive force of the bonding layer 3 becomes great, which leads to reduction in the workability. If the glass transition temperature is higher than the upper limit value noted above, the effect of improving the low temperature bondability is sometimes reduced.

The weight average molecular weight of the thermoplastic resin (particularly, the acryl-based resin) may be, but is not limited to, preferably 100, 000 or more and more preferably in the range of 150,000 to 1,000,000. If the weight average molecular weight falls within this range, it is possible to improve the film formability of the bonding layer 3 among others.

The content of the thermoplastic resin may be, but is not limited to, preferably in the range of 10 to 30 wt% and more preferably in the range of 15 to 25 wt% of the total weight of the third resin composition. If the content is smaller than the lower limit value noted above, the effect of improving the film forming ability is sometimes reduced. If the content is greater than the upper limit value noted above, the effect of improving the initial adhesion is sometimes reduced.

Although not particularly limited, it is preferred that the third resin composition further contains a coupling agent. This makes it possible to improve the adhesion of the resin, the adherend and the resin interfacial surface.

Examples of the coupling agent include silane-based coupling agents, titanium-based coupling agents and aluminum-based coupling agent. Among them, it is preferred to use the silane-based coupling agents. This makes it possible to increase the heat resistance of the bonding layer 3.

Examples of the silane-based coupling agents include vinyl trichlorosilane, vinyl trimethoxysilane, vinyl triethoxysilane, β-(3,4-epoxycyclohexyl)ethyl trimethoxysilane, γ-glycidoxypropyl trimethoxysilane, γ-glycidoxypropyl methyl dimethoxysilane, γ-methacryloxypropyl trimethoxysilane, γ-methacryloxypropyl methyl diethoxysilane, γ-methacryloxypropyl triethoxysilane, N-β (aminoethyl) γ-aminopropyl methyl dimethoxysilane, N-β (aminoethyl) γ-aminopropyl trimethoxysilane, N-β (aminoethyl) γ-aminopropyl triethoxysilane, γ-aminopropyl trimethoxysilane, γ-aminopropyl triethoxysilane, N-phenyl-γ-aminopropyl trimethoxysilane, γ-chloropropyl trimethoxysilane, γ-mercaptopropyl trimethoxysilane, 3-isocyanatepropyl triethoxysilane, 3-acryloxypropyl trimethoxysilane, and bis(3-triethoxysilylpropyl)tetrasulfane.

The content of the coupling agent may be, but is not limited to, preferably in the range of 0.01 to 10 parts by weight and more preferably in the range of 0.5 to 10 parts by weight, based on 100 parts by weight of the thermosetting resin. If the content is smaller than the lower limit value noted above, it is sometimes the case that the effect of improving the adhesion becomes insufficient. If the content is greater than the upper limit value noted above, it may sometimes be a cause of outgasing or occurrence of voids.

The thickness of the bonding layer 3 may be, but is not limited to, preferably in the range of 3 to 100 µm and more preferably in the range of 5 to 70 µm. If the thickness falls within this range, it becomes easy to control the thickness accuracy among others.

Although not particularly limited, it is preferred that the bonding force A₁ (cN/25mm) of the bonding layer 3 to the first adhesive layer 1 is smaller than the bonding force A₃ (cN/25mm) of the bonding layer 3 to a semiconductor wafer. This makes it possible to stably perform a pickup operation after the semiconductor wafer has been segmented.

Specifically, the bonding force A₃ is preferably in the range of 50 to 500 (cN/25mm) and more preferably in the range of 80 to 200 (cN/25mm). If the bonding force A₃ falls within this range, it is possible to prevent splashing of chips which would otherwise occur in a dicing process.

Although not particularly limited, it is preferred that the bonding force A₁ (cN/25mm) of the bonding layer 3 to the first adhesive layer 1 is smaller than the bonding force A₄ (cN/25mm) of the first adhesive layer 1 to the second adhesive layer 2. This makes it possible to stably perform a pickup operation after the semiconductor wafer has been segmented.

Specifically, the bonding force A₄ is preferably in the range of 100 to 1,000 (cN/25mm) and more preferably in the range of 300 to 600 (cN/25mm). If the bonding force A₄ falls within this range, the dicing property and the pickup property become superior.

The second base film (the support film) 4 serves to support the respective layers (the second adhesive layer 2, the first adhesive layer 1 and the bonding layer 3) placed thereon.

Examples of the second base film 4 include, but are not limited to: a film composed of typical thermoplastic resins such as polyethylene, polypropylene, polybutene, polybutadiene, polymethylpentene, polyvinylchloride, vinyl chloride copolymer, polyethylene terephthalate, polybutylene terephthalate, polyurethane, ethylene vinyl acetate copolymer, ionomer, ethylene (metha)acrylic acid copolymer, ethylene (metha)acrylic acid ester copolymer, polystyrene, vinyl polyisoprene, polycarbonate and the like; a film composed of a mixture of these resins; and a film formed by laminating these resins.

Among them, it is preferable to use a sheet composed of a mixture of 30 to 70 parts by weight of a polypropylene resin and 30 to 70 parts by weight of a block copolymer consisting of a polystyrene block and vinyl isoprene. It is more preferably to use a mixture of 40 to 60 parts by weight of a polypropylene resin and 40 to 60 parts by weight of a block copolymer consisting of a polystyrene block and vinyl isoprene.

The surface of this sheet may be subjected to a corona treatment in an effort to increase the adhesion of the second base film 4 with respect to the second adhesive layer 2.

The thickness of the second base film 4 may be, but is not limited to, preferably in the range of 30 to 300 µm and more preferably in the range of 50 to 200 µm. If the thickness is equal to or greater than the lower limit value noted above, it is possible to increase the stability of a dicing work. If the thickness is equal to or smaller than the upper limit value noted above, it is possible to increase the pickup property of semiconductor elements.

As described above, the film 10 includes two kinds of adhesive layers with different bonding forces, the bonding layer 3 being detachably arranged on the adhesive layers. Therefore, the adhesive layer (the first adhesive layer 1) to which the bonding layer 3 is adhesively attached shows reduced bondability and increased detachability. In the portion to which a wafer ring is adhesively attached, there is formed an adhesive layer (the second adhesive layer 2) whose bondability is great enough to hold the wafer ring.

Unlike the foregoing embodiment, the bonding layer 3 may be formed of a bonding portion 31 and a release film 32 as shown in Fig. 2.

Next, description will be made on a method for producing the film 10 shown in Fig. 1 (the present method).

The method for producing the film 10 includes a step of preparing a first base film 4b and a second base film 4; a step of obtaining a first laminated body 64 by forming the bonding layer 3 on the first base film 4b and then the first adhesive layer 1 on the bonding layer 3 at a side opposite to the first base film 4b; a step of removing outer peripheral portions of the bonding layer 3 and the first adhesive layer 1 while leaving the first base film 4b intact, the outer peripheral portions lying outside effective regions of the bonding layer 3 and the first adhesive layer 1; a step of obtaining a second laminated body 63 by forming the second adhesive layer 2 on the second base film 4; and a step of laminating the second laminated body 63 on the first adhesive layer 1 so that the second adhesive layer 2 and the first adhesive layer 1 can adjoin to each other.

Specifically, the method for producing the film 10 includes a step (first step) of obtaining the first laminated body 64 by combining the first base film 4b with the bonding layer 3 to form a bonding layer intermediate body 62 and laminating the bonding layer intermediate body 62 on the first adhesive layer 1 so that the bonding layer 3 and the first adhesive layer 1 can adjoin to each other; a step (second step) of removing outer peripheral portions of the bonding layer 3 and the first adhesive layer 1 of the first laminated body 64 while leaving the first base film 4b intact, the outer peripheral portions lying outside effective regions of the bonding layer 3 and the first adhesive layer 1; and a step (third step) of combining a second base film 4 with the second adhesive layer 2 to form the second laminated body (second adhesive layer intermediate body) 63 and laminating the second laminated body 63 on the first adhesive layer 1 so that the second adhesive layer 2 and the first adhesive layer 1 can adjoin to each other.

Hereinafter, the respective steps will be described in more detail.

### [1] First Laminated Body Forming Step (First Step)

First, a first laminated body 64 is obtained by combining the first base film 4b with a bonding layer 3 to form a bonding layer intermediate body 62 and laminating the bonding layer intermediate body 62 on a first adhesive layer 1 so that the bonding layer 3 and the first adhesive layer 1 can adjoin to each other.

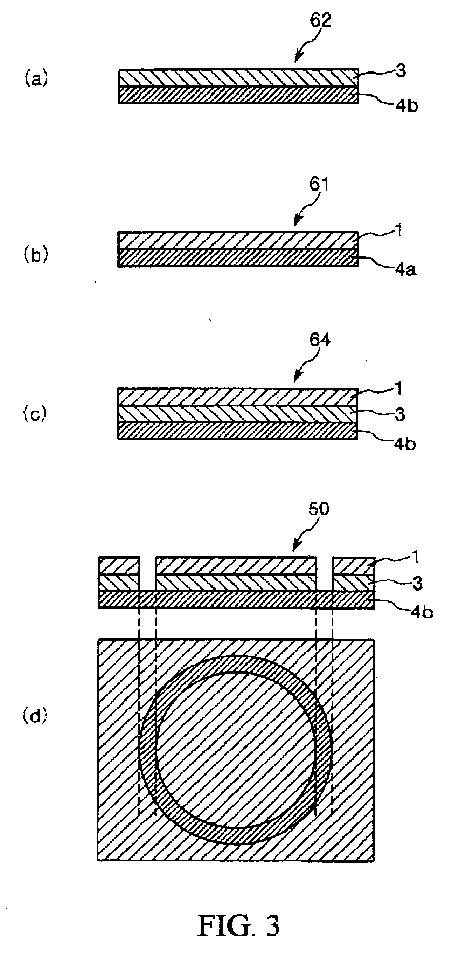

[1-1] More specifically, in this step, the bonding layer intermediate body 62 is prepared by combining the first base film 4b with the bonding layer 3 as shown in Fig. 3A.

The bonding layer intermediate body 62 can be obtained by forming the bonding layer 3 on the first base film 4b, wherein the bonding layer 3 is formed by applying a varnish-like liquid material, which is prepared by dissolving the third resin composition as a constituent material of the bonding layer 3 in a solvent, on the first base film 4b and then volatilizing the solvent.

Examples of the first base film 4b include, but are not limited to, a polypropylene film, a polyethylene film and a polypropylene terephthalate film. Since the first base film 4b is to be removed when using the film 10, the surface of the first base film 4b may be subjected to a releasing treatment. Examples of the releasing treatment include a treatment by which a releasing agent is coated on the surface of the first base film 4b and a treatment by which fine irregularities are formed on the surface of the first base film 4b. Examples of the releasing agent include a silicon-based releasing agent, an alkyd-based releasing agent and a fluorine-based releasing agent.

Examples of the solvent include methyl ethyl ketone, acetone, toluene and dimethyl formaldehyde, one or more of which may be used independently or in combination.

The task of applying or spraying the liquid material on the first base film 4b is performed by, e.g., a device such as a comma coater, a die coater, gravure coater or the like.

[1-2] Next, the first adhesive layer 1 is prepared.

The first adhesive layer 1 is composed of the first resin composition mentioned above and an adhesive agent conventionally available in this application. The first adhesive layer 1 can be produced in the following manner, for example.

Specifically, the first resin composition is dissolved in a solvent to prepare varnish. The varnish is applied or sprayed on a third base film 4a, after which the solvent is volatilized to thereby produce a first adhesive layer intermediate body 61 in which the first adhesive layer 1 is formed on the third base film 4a (see Fig. 3B). The first adhesive layer 1 is separated from the first adhesive layer intermediate body 61. In this manner, it is possible to obtain the first adhesive layer 1.

The third base film 4a used at this time is the same as the first base film 4b. The solvent is also the same as that used in dissolving the third resin composition. The task of applying or spraying the first resin composition is performed by use of the same device as used in applying or spraying the third resin composition.

[1-3] Then, the bonding layer intermediate body 62 obtained in step [1-1] and the first adhesive layer 1 obtained in step [1-2] are laminated so that the bonding layer 3 of the bonding layer intermediate body 62 and the first adhesive layer 1 can adjoin to each other, thereby obtaining a first laminated body 64 (see Fig. 3C).

It may also be possible to obtain the first laminated body 64 by laminating the first adhesive layer 1 of the first adhesive layer intermediate body 61 mentioned in step [1-2], so that it can adjoin to the bonding layer 3 of the bonding layer intermediate body 62, and then separating the third base film 4a.

The method of laminating the first adhesive layer 1 on the bonding layer 3 includes, but is not limited to, a roll laminating method and a press laminating method. Among them, it is preferred to use the roll laminating method from the standpoint of productivity. This is because the roll laminating method can continuously perform the laminating work.

As the method of separating the third base film 4a adjoining to the first adhesive layer 1, it is preferred to use a method by which the third base film 4a is separated at an angle of 90 to 180 degrees with respect to the surface of the first adhesive layer 1. If the separation angle of the third base film 4a falls within this range, it is possible to prevent the third base film 4a from being separated in a portion other than the interfacial surface of the first adhesive layer 1 and the third base film 4a.

The first laminated body 64 may also be obtained by coating the third resin composition and the first resin composition on the first base film 4b in the named order to thereby form the bonding layer 3 and the first adhesive layer 1.

[2] Second Laminated Body Forming Step (Second Step) Next, a first effective laminated body 50 is obtained by annularly removing outer peripheral portions of the bonding layer 3 and the first adhesive layer 1 of the first laminated body 64 obtained in step [1] while leaving the first base film 4b intact, the outer peripheral portions lying outside effective regions of the bonding layer 3 and the first adhesive layer 1 (see Fig. 3D).

In this regard, the terms "effective regions" refer to the regions of the bonding layer 3 and the first adhesive layer 1, which is smaller than the plan-view area of the first base film 4b and the second base film 4 and on which a semiconductor wafer 7 is placed in the below-mentioned semiconductor device manufacturing method. The terms "outer peripheral portions" refer to the portions lying between the outer diameter of the semiconductor wafer 7 and the inner diameter of the wafer ring.

[2-1] More specifically, in this step, the outer peripheral portions outside the effective regions of the bonding layer 3 and the first adhesive layer 1 are first annularly punched out while leaving the first base film 4b intact.

The task of punching out the first adhesive layer 1 can be performed by a roll-shaped mold method or a press mold method. Among them, it is preferred to use the roll-shaped mold method that assists in continuously producing the film 10.

[2-2] Then, a first effective laminated body 50 is obtained by removing the portions of the bonding layer 3 and the first adhesive layer 1 of the first laminated body 64 thus punched out.
Although the outer peripheral portions outside the effective regions are annularly (or circularly) punched out in this step, the punched-out portions may have any shape insofar as the outer peripheral portion 21 of the second adhesive layer 2 can be fixed by the wafer ring in the below-mentioned semiconductor device manufacturing method. Specifically, the punched-out portions may have a shape other than the circular shape, e.g., an oval shape such as an elliptical shape, a straw bag shape or the like, and a polygonal shape such as a rectangular shape, a pentagonal shape or the like. Although the bonding layer 3 and the first adhesive layer 1 are partially survived in the regions outside the punched-out portions according to this step, the survived portions may be removed.

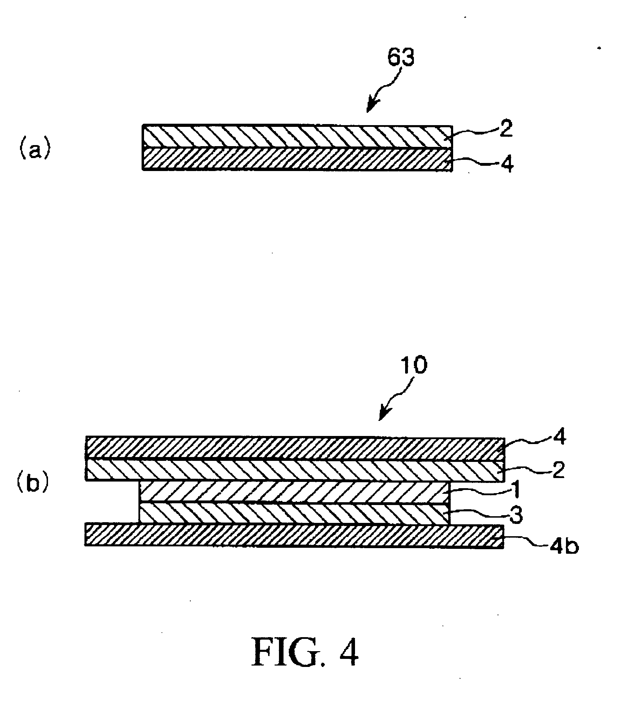

[3] Step of Forming Film (Third Step)
Next, a film for use in manufacturing semiconductor devices 10 is formed on the first base film 4b by combining a second base film 4 with a second adhesive layer 2 to form a second laminated body (second adhesive layer intermediated body) 63 and laminating the second laminated body 63 on the first adhesive layer 1 so that the second adhesive layer 2 and the first adhesive layer 1 can adjoin to each other (see Fig. 4B).

[3-1] More specifically, in this step, a second laminated body 63 is first prepared by combining a second base film 4 with a second adhesive layer 2 as illustrated in Fig. 4A.

The second laminated body 63 can be obtained by dissolving the second resin composition as a constituent material of the second adhesive layer 2 in a solvent to prepare varnish, applying or spraying the varnish on a second base film 4 into a suitable thickness, and volatilizing the solvent to form the second adhesive layer 2.

In an alternative method, a heat resistant protection sheet is prepared and the varnish is applied or sprayed on the heat resistant protection sheet. Thereafter, the solvent is volatilized to form the second adhesive layer 2. Then, the second base film 4 is laminated on the second adhesive layer 2, after which the heat resistant protection sheet is separated to thereby obtain the second laminated body 63.

[3-2] Subsequently, the first effective laminated body 50 obtained in step [1-2] and the second laminated body 63 are laminated together so that the first adhesive layer 1 of the first effective laminated body 50 and the second adhesive layer 2 of the second laminated body 63 can adjoin to each other, thereby forming a film for use in manufacturing semiconductor devices 10 on the first base film 4b (see Fig. 4B).

The method of laminating the first adhesive layer 1 on the second adhesive layer 2 includes, but is not limited to, a roll laminating method and a press laminating method. Among them, it is preferred to use the roll laminating method from the standpoint of productivity. This is because the roll laminating method can continuously perform the laminating work.

Through the steps described above, the film 10 can be formed on the first base film 4b.

When the film 10 formed on the first base film 4b in the present embodiment is used in the semiconductor device manufacturing method that makes use of the film 10, the film 10 is separated from the first base film 4b prior to its use.

The film 10 may be produced by a method other than the afore-mentioned method, e.g., the following method.

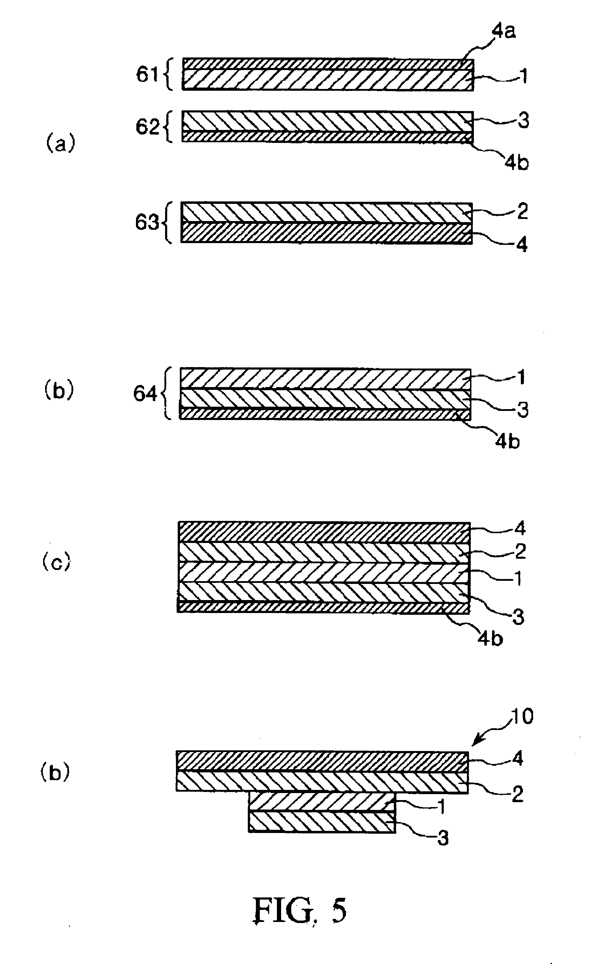

Specifically, a first adhesive layer intermediate body 61 with a first adhesive layer 1 adhesively attached to (or laminated on) a third base film 4a, a bonding layer intermediate body 62 with a bonding layer 3 adhesively attached to (or laminated on) a first base film 4b, and a second laminated body (second adhesive layer intermediate body) 63 with a second adhesive layer 2 adhesively attached to (or laminated on) a second base film (support film) 4 are first prepared by use of the afore-mentioned method (see Fig. 5A).

Next, the first adhesive layer intermediate body 61 and the bonding layer intermediate body 62 are adhesively attached to (or laminated on) each other so that the first adhesive layer 1 and the bonding layer 3 can make contact with (or adjoin to) each other. Thereafter, the third base film 4a is separated to thereby obtain a first laminated body 64 (see Fig. 5B).

Next, the second laminated body 63 is adhesively attached to (or laminated on) the first laminated body 64 so that the first adhesive layer 1 and the second adhesive layer 2 can make contact with each other (see Fig. 5C).

When in use, the outer peripheral portions outside the effective regions, i.e., the portions of the bonding layer 3 and the first adhesive layer 1 other than the portions that make contact with the semiconductor wafer, are removed by half-cutting them (in other words, the portions of the bonding layer 3 and the first adhesive layer 1 that do not make contact with the semiconductor wafer are removed) as illustrated in Fig. 5D. By doing so, it is possible to produce a film for use in manufacturing semiconductor devices 10.

Next, description will be made on a method for manufacturing a semiconductor device by use of the film 10 described above.

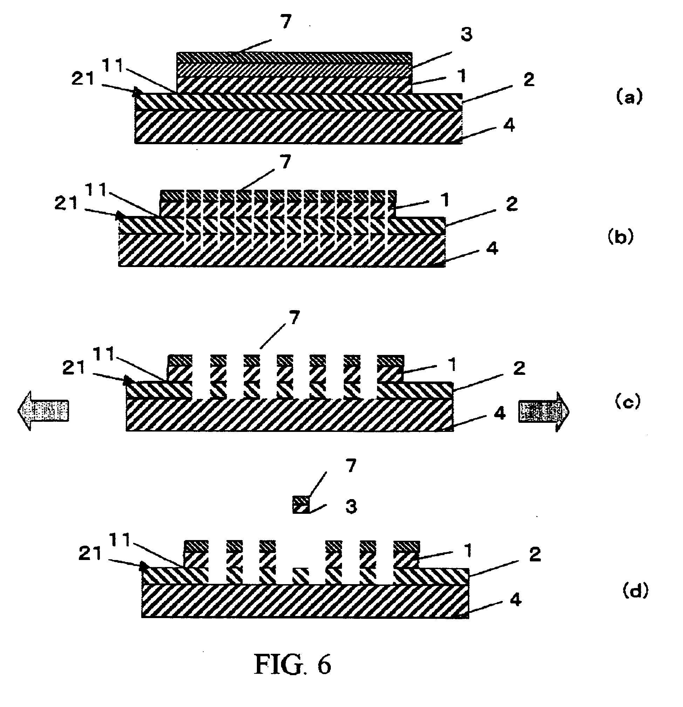

As shown in Fig. 6A, the film 10 is mounted on a dicer table not shown in the drawings. A semiconductor wafer 7 is placed on the central region of the film 10 so that the surface of the semiconductor wafer 7 on which no semiconductor element is arranged can make contact with the bonding layer 3. Then, the semiconductor wafer 7 is pressed lightly, thereby laminating the same on the film 10.

Next, the outer peripheral portion 21 of the second adhesive layer 2 is fixed in place by means of a wafer ring. Then, the semiconductor wafer 7 is diced and segmented by a blade (see Fig. 6B). At this time, the film 10 serves to absorb shocks and to prevent occurrence of cracks or other defects in the course of dicing the semiconductor wafer 7. Alternatively, the semiconductor wafer 7 may be adhesively attached to the film 10 before the film 10 is mounted on the dicer table.

Next, the film 10 is expanded by an expanding device not shown in the drawings so that individual segments of the semiconductor wafer 7 (semiconductor elements) can be spaced apart from one another with a specified gap (see Fig. 6C). Thereafter, each segment of the semiconductor wafer 7 is picked up (see Fig. 6D) and mounted on a substrate, thereby obtaining a semiconductor device.

In this regards, the film 10 includes the bonding layer 3, the first adhesive layer 1 and the second adhesive layer 2. The bonding force A₁ (cN/25mm) of the first adhesive layer 1 to the bonding layer 3 is smaller than the bonding force A₂ (cN/25mm) of the second adhesive layer 2 to the wafer ring. For that reason, when the semiconductor elements are picked up, separation occurs between the bonding layer 3 and the first adhesive layer 1, which ensures that the bonding layer 3 remains adhesively attached to the individual segments of the semiconductor wafer 7. This makes it possible to mount the semiconductor elements on the substrate without having to use any additional adhesive agent.

Since the bonding force A₁ (cN/25mm) of the first adhesive layer 1 to the bonding layer 3 is small, it is possible to pick up a thin large-sized semiconductor element without causing cracks or other defects.

### EXAMPLES

Hereinafter, the present invention will be described in detail based on Examples and Comparative Examples. However, the present invention is not limited thereto.

### <First Manufacturing Method>

### (Example 1)

### 1. Formation of First Adhesive Layer

100 parts by weight of a copolymer (A) with a weight average molecular weight of 300,000 obtained through polymerization of 30 wt% of acrylic acid 2-ethylhexyl and 70 wt% of vinyl acetate, 45 parts by weight of 5 functional acrylate monomer with a weight average molecular weight of 700, 5 parts by weight of 2,2-dimethoxy-2-phenylacetophenone and 3 parts by weight of tolylene diisocyanate (Coronate T-100, a product of Nippon Polyurethane Industry Co., Ltd.) were coated on a releasing-treated polyester film of 38 µm in thickness, so that the post-drying thickness thereof can be equal to 10 µm, and were dried for five minutes at 80°C. Thereafter, ultraviolet rays of 500mJ/cm² were irradiated to obtain a film that forms a first adhesive layer.

### 2. Formation of Second Adhesive Layer

100 parts by weight of a copolymer (B) with a weight average molecular weight of 500,000 obtained through polymerization of 70 wt% of acrylic acid butyl and 30 wt% of acrylic acid 2-ethylhexyl and 3 parts by weight of tolylene diisocyanate (Coronate T-100, a product of Nippon Polyurethane Industry Co., Ltd.) were coated on a releasing-treated polyester film of 38 µm in thickness, so that the post-drying thickness thereof can be equal to 10 µm, and were dried for five minutes at 80°C to thereby obtain a film that forms a second adhesive layer. Thereafter, a polyethylene sheet of Z 100 µm as a base material was laminated on the film.

### 3. Formation of Bonding Layer

19.92 wt% of an acrylic acid ester copolymer (a butyl acrylate-acrylonitrile-ethyl acrylate-glycidyl methacrylate copolymer, a product of Nagase Chemtex Corp., SG-80HDR with a Tg of 10°C and a weight average molecular weight of 350,000), 19.32 wt% of an epoxy resin (EOCN-1020-80, an orthocresol novolac type epoxy resin with an epoxy equivalent of 200g/eq, a product of Nippon Kayaku Co., Ltd.), 29.08 wt% of an epoxy resin (NC6000 with an epoxy equivalent of 200g/eq, a product of Nippon Kayaku Co., Ltd.), 21.91 wt% of a liquid phenol compound (MEH-8000H with a hydroxyl group equivalent of 141g/OH group, a product of Meiwa Kasei Co., Ltd.), 9.36 wt% of a solid phenol resin (PR-HF-3 with a hydroxyl group equivalent of 104g/OH group, a product of Sumitomo Bakelite Co., Ltd.), 0.15 wt% of an imidazole compound (2P4MHZ-PW, a product of Shikoku Chemicals Corp.) and 0.26 wt% of γ-glycidoxypropyltrimethoxysilane (KBM403E, a product of Shin-Etsu Chemical Co., Ltd.) were dissolved in methyl ethyl ketone (MEK) to thereby obtain resin varnish with a resin solid content of 49%.

The resin varnish thus obtained was coated on a base material, i.e., a polyethylene terephthalate film (MRX50 with a thickness of 50 µm, a product of Mitsubishi Chemical Polyester Film Corp.) by use of a comma coater and was dried for five minutes at 90°C to thereby obtain a film that forms a bonding layer of 25 µm in thickness.
4. Production of Film for use in manufacturing semiconductor devices
The first adhesive layer forming film and the bonding layer forming film were laminated together so that the first adhesive layer and the bonding layer can make contact with each other. Then, the polyester film was separated from the second adhesive layer, and polyester film was separated from the laminated first adhesive layer. The first adhesive layer and the second adhesive layer were adhesively attached to each other in a mutually contacting relationship.

Thereafter, incision extending from the polyethylene terephthalate film formed on the bonding film to the interfacial surface of the bonding layer was made by use of a mold in order to remove unnecessary adhesives or adhesive agents. A film for use in manufacturing semiconductor devices was obtained by removing the unnecessary adhesives.
5. Manufacture of Semiconductor Device
The film was adhesively attached to the rear surface of a 5-inch 200 µm wafer at 40°C, thereby obtaining a semiconductor wafer to which the film is adhesively attached.

Thereafter, the semiconductor wafer was diced (or cut) into semiconductor elements of 5mm×5mm in size by use of a dicing saw at a spindle rotation speed of 30,000rpm and a dicing speed of 50mm/sec. Then, the bonding layer and the first adhesive layer were separated from each other by thrusting up the film from the rear surface thereof, thereby obtaining semiconductor elements with the bonding layer. Die bonding was performed by pressing these semiconductor elements against a bismaleimide triazine resin substrate (of 5 to 10 µm in circuit level difference) coated with solder resist (AUS308, a product of Taiyo Ink Mfg. Co., Ltd.) under the pressing conditions of 130°C, 5N and 1.0sec. The bonding layer was half-cured by performing a heat treatment for one hour at 120°C. Thereafter, encapsulating was performed with an encapsulation resin EME-G760. Ten semiconductor devices were obtained by curing the encapsulation resin through a heat treatment made at 175°C for two hours.

### (Example 2)

The same procedures as used in Example 1 were performed except that the composition of the first adhesive layer is changed as follows.

Specifically, the first adhesive layer is composed of 100 parts by weight of a copolymer (A) with a weight average molecular weight of 300,000 obtained through polymerization of 30 wt% of acrylic acid 2-ethylhexyl and 70 wt% of vinyl acetate, 45 parts by weight of urethane acrylate and 3 parts by weight of tolylene diisocyanate (Coronate T-100, a product of Nippon Polyurethane Industry Co., Ltd.)

### (Example 3)

The same procedures as used in Example 1 were performed except that the blending quantity of tolylene diisocyanate is increased in the composition of the first adhesive layer and further that the overall composition of the first adhesive layer is changed as follows.

Specifically, the first adhesive layer is composed of 100 parts by weight of a copolymer (B) with a weight average molecular weight of 500,000 obtained through polymerization of 70 wt% of acrylic acid butyl and 30 wt% of acrylic acid 2-ethylhexyl and 10 parts by weight of tolylene diisocyanate (Coronate T-100, a product of Nippon Polyurethane Industry Co., Ltd.).

### (Example 4)

The same procedures as used in Example 1 were performed except that the composition of the bonding layer is changed as follows.

Specifically, the bonding layer is composed of 100 parts by weight of an acrylic acid copolymer (a ethyl acrylate-butyl acrylate-acrylonitrile-acrylic acid-hydroxy ethyl acrylate copolymer, a product of Nagase Chemtex Corp., SG-708-6DR with a Tg of 6°C and a weight average molecular weight of 800,000), 40 parts by weight of a cresol novolac epoxy resin (EOCN-1020-80 with an epoxy equivalent of 200g/eq, a product of Nippon Kayaku Co., Ltd.), 20 parts by weight of an epoxy resin (NC6000 with an epoxy equivalent of 197g/eq, a product of Nippon Kayaku Co., Ltd.), 3 parts by weight of an imidazole compound (IB2MZ with a meting point of 50°C and in a liquid phase, a product of Shikoku Chemicals Corp.) and 0.2 parts by weight of γ-glycidoxypropyltrimethoxysilane (KBM403, a product of Shin-Etsu Chemical Co., Ltd.).

### (Comparative Example 1)

The same procedures as used in Example 1 were performed except that the film is produced from the bonding layer and the second adhesive layer without using the first adhesive layer.

Specifically, the film is produced by laminating a bonding layer forming film and a second adhesive layer forming film together so that the second adhesive layer and the bonding layer can make contact with each other.

### (Comparative Example 1)

The same procedures as used in Example 1 were performed except that the composition of the second adhesive layer is changed as follows.

Specifically, the second adhesive layer is composed of 100 parts by weight of a copolymer (A) with a weight average molecular weight of 300,000 obtained through polymerization of 30 wt% of acrylic acid 2-ethylhexyl and 70 wt% of vinyl acetate, 45 parts by weight of urethane acrylate and 3 parts by weight of tolylene diisocyanate (Coronate T-100, a product of Nippon Polyurethane Industry Co., Ltd.).

The respective films and the respective semiconductor devices obtained in the foregoing Examples and Comparative Examples were subjected to the following evaluation. The results of evaluation are shown in Table 1.

### 1. Evaluation of Bonding Force

The bonding forces A₁ to A₄ were measured by, e.g., cutting the first adhesive layer (film) into a 25mm-wide strip, adhesively attaching the strip to the second adhesive layer (film) at 23°C (the room temperature) and peeling the first adhesive layer (film) at 23°C (the room temperature) with a peeling angle of 180 degrees (at which time the pulling speed of the adhesive film is 300mm/min). The same evaluation as noted above was conducted for other parts.

### 2. Dicing Property

The bonding layer of each of the films obtained in the foregoing Examples and Comparative Examples was pressed at 40°C against a semiconductor wafer (of 8 inches in diameter) whose surface is grinded to have a thickness of 0.10mm. Thereafter, the semiconductor wafer was diced into semiconductor elements of 10mm × 10mm in size. The evaluation was conducted for ten semiconductor elements (n=10) by measuring the number of semiconductor elements weakly attached to and consequently separated from the film. The symbols in Table 1 are defined as follows.

A: None of the semiconductor elements separated.

B: One or two of the semiconductor elements separated.

C: Three or four of the semiconductor elements separated.

D: Five to ten of the semiconductor elements separated.

### 3. Drop of Semiconductor Elements during Expanding

The diced samples of semiconductor elements were mounted on a bonder (AD898, a product of ASM Corp.) and were expanded by 9mm. Then, drop or non-drop of the semiconductor elements was investigated. The symbols in Table 1 are defined as follows.

A: 2% or less of the semiconductor elements dropped.

B: More than 2% and equal to or less than 30% of the semiconductor elements dropped.

C: More than 30% and equal to or less than 50% of the semiconductor elements dropped.

D: More than 50% of the semiconductor elements dropped.

### 4. Pickup Property

The diced samples of semiconductor elements were mounted on a bonder (AD898, a product of ASM Corp.) and were expanded by 6mm. Thereafter, the semiconductor elements were picked up by thrusting up them with a needle. The percentage of the semiconductor elements picked up successfully was evaluated. The symbols in Table 1 are defined as follows.

A: 90% or more of the semiconductor elements picked up.

B: 70% or more and less than 98% of the semiconductor elements picked up.

C: 50% or more and less than 70% of the semiconductor elements picked up.

D: Less than 50% of the semiconductor elements picked up.

### 5. Initial Embedment Property

In evaluating the initial embedment property (or the circuit filling property), the percentage of the film filled in circuit steps of an organic substrate was measured by a scanning acoustic tomography (SAT) with respect to the pre-encapsulating semiconductor devices obtained in the Examples and the Comparative Examples. The symbols in Table 1 are defined as follows.

A: The filling percentage is 90% or more to 100%.

B: The filling percentage is 80% or more to less than 90%.

C: The filling percentage is 40% or more to less than 80%.

D: The filling percentage is less than 40%.

**Table 1**

| | Example 1 | Example 2 | Example 3 | Example 4 | Comparative Example 1 | Comparative Example 2 |
|---|---|---|---|---|---|---|
| Bonding Force A₁(cN/25mm) | 50 | 25 | 50 | 50 | - | 50 |
| Bonding Force A₂(cN/25mm) | 700 | 700 | 350 | 350 | 700 | 25 |
| A2/A1 | 14 | 28 | 7 | 7 | - | 0.5 |
| Bonding Force A₃(cN/25mm) | 200 | 200 | 200 | 100 | 200 | 200 |
| Bonding Force A₄(cN/25mm) | 600 | 600 | 300 | 300 | - | 50 |
| Dicing Property | A | B | A | B | B | _** |
| Drop of Semiconductor Elements during Expanding | A | A | B | B | B | _** |
| Pickup Property | A | A | A | A | D | _** |
| Initial Embedment Property | A | A | A | A | _* | _** |

| | | | | | | |
|---|---|---|---|---|---|---|
| _* : later evaluations are cancelled because the semiconductor elements were not picked up by thrusting up them with a needle. _** : later evaluations are cancelled because in dicing the semiconductor wafer into semiconductor elements, the film separated from the wafer ring. | | | | | | |

As can be seen in Table 1, the dicing property is superior in case of using the films of Examples 1 to 4.

It was also confirmed that little semiconductor elements are dropped in the expanding process in case of using the films of Examples 1 to 4.

Table 1 also reveals that the films of Examples 1 to 4 are superior in the initial embedment property.

### <Second Manufacturing Method>

### (Example 5)

### 1. Step of Forming a First Adhesive Layer

100 parts by weight of a copolymer (A) with a weight average molecular weight of 300,000 obtained through polymerization of 30 wt% of acrylic acid 2-ethylhexyl and 70 wt% of vinyl acetate, 45 parts by weight of 5 functional acrylate monomer with a weight average molecular weight of 700, 5 parts by weight of 2,2-dimethoxy-2-phenylacetophenone and 3 parts by weight of tolylene diisocyanate (Coronate T-100, a product of Nippon Polyurethane Industry Co., Ltd.) were dissolved in methyl ethyl ketone (MEK) to thereby obtain resin varnish with a resin solid content of 20%. The varnish was coated on a releasing-treated polyester film of 38 µm in thickness by use of a comma coater, so that the post-drying thickness thereof can be equal to 10 µm, and was dried for five minutes at 80°C. Thereafter, ultraviolet rays of 500 mJ/cm² were irradiated to obtain a first adhesive layer intermediate body 61 in which a first adhesive layer 1 is laminated on a third base film 4a.

### 2. Step of Forming a second laminated body (Second Adhesive Layer Intermediate Body)

100 parts by weight of a copolymer (B) with a weight average molecular weight of 500,000 obtained through polymerization of 70 wt% of acrylic acid butyl and 30 wt% of acrylic acid 2-ethylhexyl and 3 parts by weight of tolylene diisocyanate (Coronate T-100, a product of Nippon Polyurethane Industry Co., Ltd.) were dissolved in methyl ethyl ketone (MEK) to thereby obtain resin varnish with a resin solid content of 20%. The varnish was coated on a releasing-treated polyester film of 38 µm in thickness by use of a comma coater, so that the post-drying thickness thereof can be equal to 10 µm, and was dried for five minutes at 80°C to thereby obtain a film that forms a second adhesive layer 2. Thereafter, a polyethylene sheet of 100 µm in thickness as a second base film 4 was laminated on the film, and the polyester film was separated to thereby obtain a second laminated body 63.

### 3. Step of Forming a Bonding Layer Intermediate Body

19.92 wt% of an acrylic acid ester copolymer (a butyl acrylate-acrylonitrile-ethyl acrylate-glycidyl methacrylate copolymer, a product of Nagase Chemtex Corp., SG-80HDR with a Tg of 10°C and a weight average molecular weight of 350,000), 19.32 wt% of an epoxy resin (EOCN-1020-80, an orthocresol novolac type epoxy resin with an epoxy equivalent of 200 g/eq, a product of Nippon Kayaku Co., Ltd.), 29.08 wt% of an epoxy resin (NC6000 with an epoxy equivalent of 200g/eq, a product of Nippon Kayaku Co., Ltd.), 21.91 wt% of a liquid phenol compound (MEH-8000H with a hydroxyl group equivalent of 141g/OH group, a product of Meiwa Kasei Co., Ltd.), 9.36 wt% of a solid phenol resin (PR-HF-3 with a hydroxyl group equivalent of 104g/OH group, a product of Sumitomo Bakelite Co., Ltd.), 0.15 wt% of an imidazole compound (2P4MHZ-PW, a product of Shikoku Chemicals Corp.) and 0.26 wt% of γ-glycidoxypropyltrimethoxysilane (KBM403E, a product of Shin-Etsu Chemical Co., Ltd.) were dissolved in methyl ethyl ketone (MEK) to thereby obtain resin varnish with a resin solid content of 49%.

The resin varnish thus obtained was coated on a first base film 4b, i.e., a polyethylene terephthalate film (MRX50 with a thickness of 50 µm, a product of Mitsubishi Chemical Polyester Film Corp.) by use of a comma coater and was dried for five minutes at 90°C to thereby obtain a bonding layer intermediate body 62 in which a bonding layer of 25 µm in thickness is laminated on the first base film 4b.

### 4. Step of Forming a First Laminated Body

Next, the first adhesive layer 1 of the first adhesive layer intermediate body 61 and the bonding layer 3 of the bonding layer intermediate body 62 were placed in a mutually opposing relationship and were attached to each other by use of a roll laminator under the laminating conditions of 25°C, 0.1MPa and 20mm/min. The third base film 4a adjoining to the first adhesive layer 1 was separated at an angle of 150 degrees relative to the surface of the first adhesive layer 1, thereby obtaining a first laminated body 64.

### 5. Removal Step

Using a roll-shaped mold, the bonding layer 3 and the first adhesive layer 1 of the first laminated body 64 were punched away with a size greater than the outer diameter of the semiconductor wafer but smaller than the inner diameter of the wafer ring. Unnecessary portions were removed to obtain a first effective laminated body 50.

### 6. Attaching Step

The first adhesive layer 1 of the first effective laminated body 50 and the second adhesive layer 2 of the second laminated body 63 were attached together by use of a roll laminator under the conditions of 25°C, 0.1MPa and 20mm/min, thereby obtaining a film for use in manufacturing semiconductor devices 10 formed on the first base film 4b.

### 7. Manufacture of Semiconductor Device

The film 10 was separated from the first base film 4b and adhesively attached to the rear surface of a 5-inch 200 µm wafer at 40°C, thereby obtaining a semiconductor wafer to which the film is adhesively attached.

Thereafter, the semiconductor wafer was diced (or cut) into semiconductor elements of 5mm×5mm in size by use of a dicing saw at a spindle rotation speed of 30,000rpm and a dicing speed of 50mm/sec. Then, the bonding layer and the first adhesive layer were separated from each other by thrusting up the film from the rear surface thereof, thereby obtaining semiconductor elements with the bonding layer 3. Die bonding was performed by pressing these semiconductor elements against a bismaleimide triazine resin substrate (of 5 to 10 µm in circuit level difference) coated with solder resist (AUS308, a product of Taiyo Ink Mfg. Co., Ltd.) under the pressing conditions of 130°C, 5N and 1.0sec. The bonding layer 3 was half-cured by performing a heat treatment for one hour at 120°C. Thereafter, encapsulating was performed with an encapsulation resin EME-G760. Ten semiconductor devices were obtained by curing the encapsulation resin through a heat treatment made at 175°C for two hours.

The film and the semiconductor devices thus obtained were subjected to the following evaluation.

### 1. Evaluation of Bonding Force

The bonding forces A₁ to A₄ were measured by, e.g., cutting the first adhesive layer (film) into a 25mm-wide stripe adhesively attaching the strip to the second adhesive layer (film) at 23°C (the room temperature) and peeling the first adhesive layer (film) at 23°C (the room temperature) with a peeling angle of 180 degrees (at which time the pulling speed of the adhesive film is 300mm/min). The same evaluation as noted above was conducted for other parts. The results shows that the bonding force A₁ is 50 cN/25mm, the bonding force A₂ being 700 cN/25mm, the bonding force A₃ being 200 cN/25mm, the bonding force A₄ being 600 cN/25mm and the A₂/A₁ being 14.

### 2. Dicing Property

The bonding layer of the film obtained in Example 5 was pressed at 40°C against a semiconductor wafer (of 8 inches in diameter) whose surface is grinded to have a thickness of 0.10mm. Thereafter, the semiconductor wafer was diced into semiconductor elements of 10mm × 10mm in size. The evaluation was conducted by measuring the number of semiconductor elements weakly attached to and consequently separated from the film. The results show that the semiconductor elements were not separated. The evaluation was conducted for ten semiconductor elements (n=10).

### 3. Drop of Wafer Ring during Expanding

The diced samples of semiconductor elements were mounted on a bonder (AD898, a product of ASM Corp.) and were expanded by 9mm. Then, drop or non-drop of the film from the wafer ring was investigated. The results show that the film was not dropped. The evaluation was conducted for ten semiconductor elements (n=10).

### 4. Pickup Property

The diced samples of semiconductor elements were mounted on a bonder (AD898, a product of ASM Corp.) and were expanded by 6mm. Thereafter, the semiconductor elements were picked up by thrusting up them with a needle. The percentage of the semiconductor elements picked up successfully was evaluated. The results show that no semiconductor element failed to be picked up.

### 5. Evaluation of Crack Resistance

The semiconductor devices obtained were subjected to a wetting treatment under the conditions of 85°C/85%RH/168 hours and then subjected to IR reflow three times at 260°C. Thereafter, the crack resistance was evaluated by a scanning acoustic tomography (SAT). The results show that no crack was generated in any semiconductor device.

As is apparent from the above evaluation results, the dicing property, the expanding property, the pickup property and the crack resistance become superior in case of using the film obtained in Example 5.

### INDUSTRIAL APPLICABILITY

With the present invention, it is possible to provide a film for use in manufacturing semiconductor devices capable of satisfying the function required in the portion of an adhesive bonding film to be bonded to a semiconductor wafer and the function required in the portion of the adhesive bonding film to be bonded to a wafer ring, both of the functions differing from each other in the adhesive bonding film formed by combining an adhesive sheet and a film-like die attach material together.

The balance between the dicing property and the pickup property is greatly improved by setting the ratio (A₂/A₁) of the bonding force A₁ to the bonding force A₂ at a specific value. This provides industrial applicability.

## Claims

1. A film for use in manufacturing semiconductor devices, the film having a first portion and a second portion different from the first portion, the film being adapted to be used in dicing a semiconductor wafer in a state that the semiconductor wafer is bonded to the first portion of the film while a wafer ring is bonded to the second portion of the film, the film comprising:
a bonding layer having a first surface which forms the first portion of the film and a second surface opposite to the first surface;
a first adhesive layer bonding to the second surface of the bonding layer; and
a second adhesive layer bonding to the first adhesive layer at a side opposite to the bonding layer, the second adhesive layer having an outer peripheral portion extending beyond an outer peripheral edge of the first adhesive layer wherein the outer peripheral portion acts as the second portion of the film,
wherein the bonding force A₁ (cN/25mm) of the first adhesive layer to the bonding layer is smaller than the bonding force A₂ (cN/25mm) of the second adhesive layer to the wafer ring.

2. The film for use in manufacturing semiconductor devices as claimed in claim 1, wherein the ratio (A₂/A₁) of the bonding force A₁ to the bonding force A₂ is in the range of 1.2 to 100.

3. The film for use in manufacturing semiconductor devices as claimed in claim 1, wherein the bonding force A₁ is in the range of 10 to 80 cN/25mm.

4. The film for use in manufacturing semiconductor devices as claimed claim 1, wherein the bonding force A₂ is in the range of 100 to 1,000 cN/25mm.

5. The film for use in manufacturing semiconductor devices as claimed in claim 1, wherein the bonding force A₃ (cN/25mm) of the bonding layer to the semiconductor wafer is greater than the bonding force A₁.

6. The film for use in manufacturing semiconductor devices as claimed in claim 1, wherein the bonding layer has a release film.

7. A method for producing the film defined by claim 1, comprising:
preparing a first base film and a second base film;
obtaining a first laminated body by forming the bonding layer on the first base film and then the first adhesive layer on the bonding layer at a side opposite to the first base film;
removing outer peripheral portions of the bonding layer and the first adhesive layer while leaving the first base film intact, the outer peripheral portions lying outside effective regions of the bonding layer and the first adhesive layer;
obtaining a second laminated body by forming the second adhesive layer on the second base film; and
laminating the second laminated body on the first adhesive layer so that the second adhesive layer and the first adhesive layer can adjoin to each other.

8. A semiconductor device manufactured by use of the film defined by claim 1.
